# EUROPEAN PATENT APPLICATION

(11) **EP 2 752 860 A2**
(43) Date of publication of application: **09.07.2014**
(21) Application number: 13196581.6
(22) Date of filing: 11.12.2013
(51) Int. Cl.: H01F 27/36, H01F 38/14

(54) **Multi-layered magnetic shields**

(30) Priority: 26.12.2012 US 201213726779
(71) Applicant: Nokia Corporation, 02610 Espoo (FI)
(72) Inventor: Lampinen, Harri, 33710 Tampere (FI)
(74) Representative: Nokia Corporation

(57) **Abstract**

A device may include a multiple layer ferrite shield to protect device components during charging of a battery of the device based on magnetic induction. In some examples, the device may include a ferrite shield comprising a first layer and a second layer. The first layer may be composed of a material having first magnetic properties and the second layer may be composed of a material having second magnetic properties. Further, the first magnetic properties may be different from the second magnetic properties.

## Description

### BACKGROUND

In various existing charging schemes, a wireless device may be placed on a charging pad and a battery of the wireless device may be wirelessly charged through magnetic induction. The wireless device may include a ferrite shield designed to protect electronic components within the device (e.g., battery, chassis, printed writing board, etc.) from a magnetic field generated by the charging pad. These shields, however, often do not function as intended.

In some instances, wireless charging pads have been known to saturate the ferrite shields resulting in undesired power leakage inside the wireless device. Further, wireless charging pads may include a magnet that may saturate known ferrite shields (or other corresponding protection materials) used to protect metal (or other magnetically active) parts of the wireless device. Power leakage may result in undesired heating of certain portions of the wireless device due to, for instance, induced eddy currents within metal/conductive structures (e.g., electronic components) of the device. For example, eddy currents in a batteries' casing, internal structure, electrolyte, etc. could cause the battery to overheat creating a hazardous condition for the user. One way to try to avoid power leakage is to increase the thickness of the ferrite shield. This solution, however, may require increasing the thickness of the wireless device, thus preventing manufacture of a device that is slim.

### SUMMARY

This Summary is provided to introduce a selection of concepts in a simplified form that are further described below in the Detailed Description. This Summary is not intended to identify key or essential features of the invention.

Embodiments include, without limitation, a device including a multiple layer ferrite shield to protect device components during charging of a battery of the device based on magnetic induction. In some examples, the device may include a ferrite shield comprising a first layer and a second layer. The first layer may be composed of a material having a first magnetic permeability and the second layer may be composed of a material having a second magnetic permeability. Further, the first magnetic permeability may be different from the second magnetic permeability. Embodiments further include, without limitation, devices and/or systems configured to perform methods for manufacturing the ferrite shield.

Additional embodiments are disclosed herein.

### BRIEF DESCRIPTION OF THE DRAWINGS

Some embodiments are illustrated by way of example, and not by way of limitation, in the figures of the accompanying drawings and in which like reference numerals refer to similar elements.
FIG. 1 is a diagram showing a device and a charging pad in accordance with example embodiments.
FIGS. 2A-B illustrate an example arrangement of a receiving coil relative to a transmitting coil for measuring power leakage at a load.
FIG. 3A illustrates examples of power loss for various ferrite materials of which a shield may be composed.
FIG. 3B illustrates an example magnetization curve according to various embodiments.
FIGS. 4A-F illustrate cross sectional views of ferrite shields having multiple layers in accordance with example embodiments.
FIG. 5 illustrates a chart depicting power leakage for various different ferrite shields in accordance with example embodiments.
FIGS. 6A-6B illustrate an example arrangement of a load relative to transmitting and receiving coils for measuring different shields based on distance in accordance with example embodiments.
FIGS. 6C illustrates tradeoffs between power leakage and different shields based on distance in accordance with example embodiments.
FIG. 7 is a flow chart of an example method in accordance with example embodiments.
FIG. 8 shows an exemplary device in accordance with example embodiments.

### DETAILED DESCRIPTION

In the following description of various embodiments, reference is made to the accompanying drawings, which form a part hereof, and in which various embodiments are shown by way of illustration. It is to be understood that there are other embodiments and that structural and functional modifications may be made. Embodiments of the present invention may take physical form in certain parts and steps, examples of which will be described in detail in the following description and illustrated in the accompanying drawings that form a part hereof.

As used herein, "ferrite" refers generally to materials including at least one ferromagnetic material (e.g., cobalt, nickel, iron, gadolinium, etc.) combined with one or more other materials. Shields made with ferrite materials have a permeability, structure, and shape that provide a reluctance path for magnetic fields that is lower than the reluctance path through the components that are intended to be shielded. Examples of such materials may include nickel-iron (NiFe) alloys, silicon-iron (SiFe) alloys, cobalt-iron (CoFe) alloys, and other such materials. Various embodiments may include, for example, Vitroperm®, which has a composition of Fe₇₃Cu₁Nb₃Si₁₆B₇.

As used herein, "permeability" and "magnetic permeability" refer to relative magnetic permeability, which is equal to the ratio of absolute magnetic permeability of a material (µₐ) to the magnetic permeability of free space (µₒ). Because relative permeability is a ratio (µₐ / µₒ), the value is unitless.

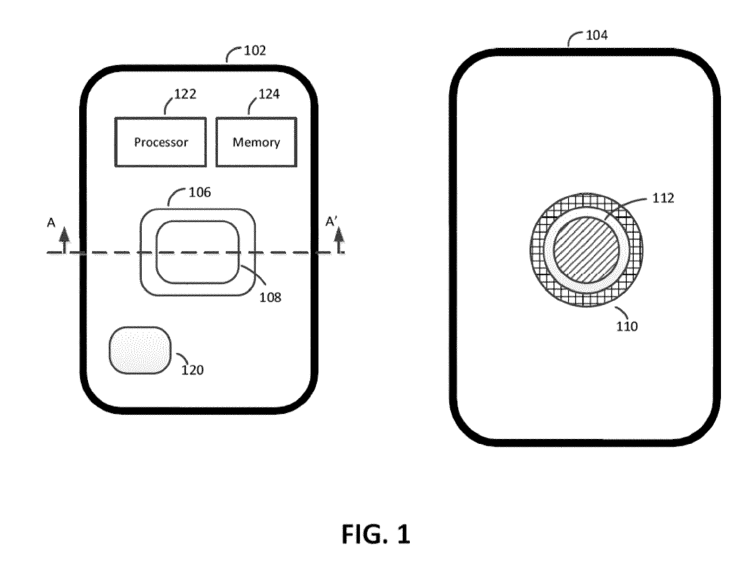

FIG. 1 is a diagram showing a device 102 and a charging pad 104 in accordance with example embodiments. Device 102 may be capable of communicating wirelessly via a wireless network (e.g., wireless local area network, cellular network, etc.). For example, device 102 may be a mobile phone, a smart phone, a cellular phone, a laptop computer, a mobile device, or other device. The charging pad 104 may be coupled to a power source for charging device 102 through magnetic induction when device 102 is placed on top of pad 104. Charging pad 104 may also be other types of devices or boxes instead of or in addition to a pad. FIG. 1 illustrates pad 104 separated from device 102 to illustrate the components of each.

Device 102 may include a ferrite shield 106, a receiving coil 108, a battery 120, at least one processor 122, at least one memory 124, along with other components not depicted. Ferrite shield 106 may protect battery 120, chassis, printed circuit board, as well as other electronic components, and device structure from undesired leakage of power generated by pad 104 during charging. Ferrite shield 106 may be configured (e.g., formed into a shape and/or positioned) to reduce exposure of at least one internal component of device 102 to a magnetic field generated by charging pad 104. In various embodiments, ferrite shield 106 reduces exposure of an internal component of device 102 by being placed behind receiving coil 108 (e.g., placed on the side of receiving coil 108 opposite charging pad 104 and between receiving coil 108 and the component to be protected). Charging pad 104 may include a transmitting coil 110, and a power source interface, such as a plug for connecting to an external power source. In certain variations, charging pad 104 may further include a magnet 112.

To charge device 102, a user may place device 102 on top of pad 104 such that receiving coil 108 at least partially overlaps a magnetic field generated with transmitting coil 110. When device 102 is placed overtop charging pad 104, charging pad 104 may cause alternating electric current to flow through transmitting coil 110. The electric current may cause the transmitting coil 110 to emit an alternating magnetic field. Field lines of the magnetic field may pass through receiving coil 108 when positioned in proximity of transmitting coil 110, thereby inducing alternating electric current to flow through receiving coil 108 by magnetic induction. Device 102 may rectify the alternating electric current induced in receiving coil 108 to produce direct current power to charge battery 120 and/or to power other components of device 102 (e.g., processor, memory, display, etc.).

Alignment of receiving coil 108 relative to transmitting coil 110 affects the amount of power induced in receiving coil 108. Efficiency of the magnetic induction may be increased by positioning device 102 to maximize the amount of generated magnetic flux crossing within the loops of receiving coil 108. In various embodiments, a maximum efficiency may be achieved by placing receiving coil 108 such that the loops of coil 108 are concentric with the loops of transmitting coil 110. A user, however, may not be able to determine when receiving coil 108 is concentric with transmitting coil 110, because receiving coil 108 may be internal to device 102 and transmitting coil 110 may be internal to pad 104. In some instances, a user may place device 102 on pad 104 such that receiving coil 108 and transmitting coil 110 only partially overlap. To prevent misalignment, pad 104 may include an alignment device, such as magnet 112, which is used to attract/repel device 102 to align receiving coil 108 to be at least partially overlapping with transmitting coil 110.

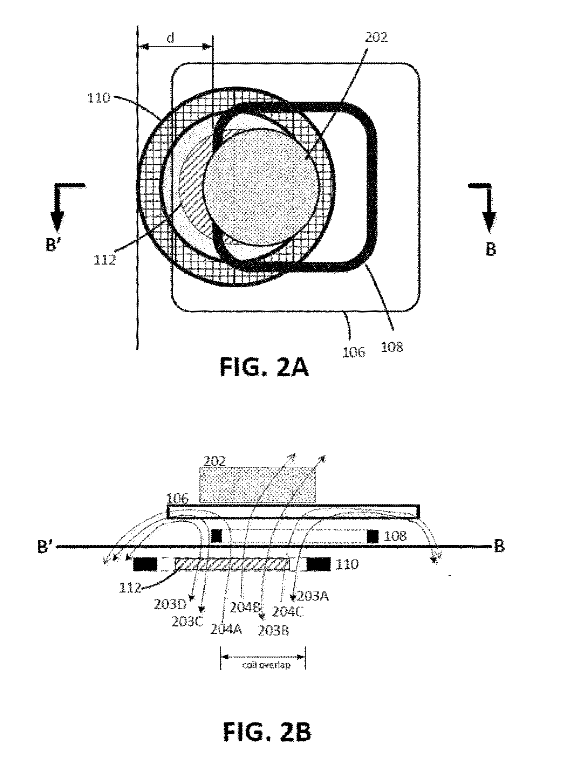

FIG. 2A illustrates a detailed view of the receiving coil 108 and transmitting coil 110 arrangement of FIG. 1, and FIG. 2B illustrates a cross-section view B-B' of FIG. 2A. Cross -section line B-B' in FIG. 2B is indicative of a boundary between device 102 and pad 104. With reference to FIGS. 2A and 2B, a load 202 (e.g., metal plate) is placed on an opposite side of ferrite shield 106 relative to receiving coil 108. Receiving coil 108 is positioned between ferrite shield 106 and transmitting coil 110 with at least a portion of the receiving coil 108 and transmitting coil 110 overlapping as indicated in FIG. 2B. Load 202 may represent internal components of device 102 that are to be at least partially protected by ferrite shield 106 from the influence of the magnetic field generated by transmitting coil 110. The magnetic field generated by 110 is represented in FIG. 2B by flux lines 203A-203D, represented with double arrows to indicate that the field is alternating. Other components of device 102 and pad 104 are not shown in FIGS. 2A and 2B to prevent obscuring of this example.

Ferrite shield 106 may shield components (e.g., load 202) primarily by providing a low reluctance magnetic flux path away from the shielded components. Because the ferrite shield has a higher permeability than the air and device packaging (e.g., plastics, semiconductor, non-ferrous metals, etc.) behind the shield, the magnetic flux emanating from the transmitting coil 110 (i.e., through the page plane in FIG. 2A) will follow the shape of the shield (e.g., 203A and 203C) rather than passing through the shield (e.g., 203B) to the components being protected.

Undesired power leakage from transmitting coil 110 to load 102 (and to other device 106 components) depends upon the amount of magnetic field that must be channeled away from the protected components by shield 106 and by the capacity of shield 106 to support the magnetic field. Once the magnetic field exceeds the shield's capacity to support the magnetic field, the shield saturates (i.e., exceeds the magnetic flux density saturation point), resulting in the excess magnetic field that exceeds the shield's capacity to pass through the shield reaching load 202 (e.g., 203B).

Factors that affect the amount of magnetic field reaching shield 106 may include the power draw from receiving coil 108 to power device 102, the non-concentric alignment of the receiving coil 108 over transmitting coil 110, and the presence of the optional alignment magnet 112. Factors that affect the capacity of shield 106 to support a magnetic field include the permeability of the materials and the structure of the shield, which are reflected in the shield's magnetization curve (further discussed below).

For the magnetic flux generated by transmitting coil 110 that passes through receiving coil 108, the amount of energy that is transferred to coil 108 depends on the electrical load on the coil. When loaded, a current is induced in receiving coil 108, resulting in power transfer from the magnetic flux passing through coil 108. The resulting induced current reduces the magnetic flux that reaches the shield by generating a reverse magnetic field that cancels the magnetic field generated by coil 110 (i.e., Lenz's law). If the coil is not loaded, however, (e.g., not powering any electronics or battery) the electric flux will not transfer any power and will continue to the shield as if coil 108 is not present. The result of an unloaded or under-loaded receiving coil 108 may contribute to the saturation of shield 106.

Non-concentric alignment of receiving coil 108 and transmitting coil 110 may affect the amount of magnetic flux that reaches the shield in at least a few respects. As shown in FIG. 2B, when the coils are misaligned, only a portion of the magnetic field passes through receiving coil 108, thus resulting in only a portion of the transmitted power being coupled to the receiving coil 108. As one consequence, magnetic flux not passing through coil 108 (e.g., flux 203D) carries extra power that cannot be transferred to receiving coil 108, and thus, this extra magnetic flux must be shielded from load 202 by shield 106. As a second consequence, to transfer the same amount of power to the misaligned receiving coil 108 compared to the transmitted power when the coils are aligned, the overall magnetic field generated by coil 110 must be increased. (i.e., to produce the same amount of magnetic flux through receiving coil 108). Both of these effects may result in greater magnetic flux that must be channeled by shield 106, and thus, may also contribute to the saturation of shield 106.

The presence of the optional alignment magnet 112 may also affect the saturation of shield 106. As shown in FIG. 2B, magnet 112 may generate additional magnetic flux reaching shield 106. The additional magnetic flux from magnet 112 is represented by field lines 204A - 204C, which are illustrated with single arrows to indicate that the magnetic field is not alternating. The magnetic flux 204A-204C generated by magnet 112 may have the same effects as magnetic flux 203A to 203D, except that since the 204A - 204C is non-alternating, none of the flux power is transferred to coil 108.

As noted above, the ability of shield 106 to protect load 202 is affected by both the amount of magnetic flux (from transmitting coil 110 and magnetic 112) to be shielded, and by the capacity of shield 106 to support a magnetic field. To address the problem of shielding components of device 102, various embodiments are directed to the testing and selection of different shield materials and shield structures in a worst-case configuration of an under-loaded and misaligned receiving coil 108, combined optionally with the presence of an alignment magnet 112 as shown in FIGS. 2A and 2B. Various embodiments include shields having different materials and structures that provide effective shielding (e.g., do not saturate) when in the presence of magnetic 112 and when configured with a worst case misalignment (distance d). Distance d as shown in FIG. 2A may be the maximum offset at which the transmitting coil still operates to transmit power to receiving coil 108.

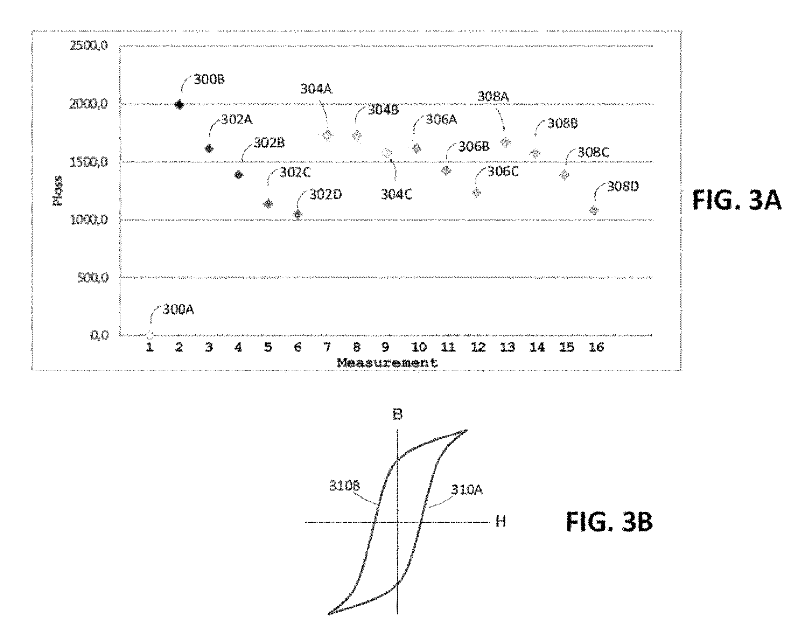

The material of which shield 106 is composed may affect the amount of power leakage. FIG. 3A illustrates examples of power leakages measured at load 202 for various ferrite materials of which shield 106 may be composed. To obtain the power leakage measurements, device 102 was placed on pad 104 such that receiving coil 108 partially overlapped, but was misaligned, with transmitting coil 110, as shown in FIGS. 2A and 2B. The misalignment during the testing may be set by varying distance d in FIG. 2A while measuring power transfer to find the worst case transfer while pad 106 still transfers power (e.g.., until pad 106 aborts the operation, because no coil 108 is sensed as being present).

In FIG. 3A, four different ferrite "families" have been measured, where each family is composed of a material having a different magnetic permeability. Magnetic permeability, represented by the letter "µ", is the measure of the degree of magnetization that a material obtains in response to an applied magnetic field.

While each of the families above are identified by their magnetic permeability, the materials behavior in FIG. 3A may be affected by numerous material properties that are reflected in the materials magnetization curve, which plots a materials magnetic flux density B supported in the material versus the magnetizing field H inducing the magnetic flux. An example of the magnetization curve (also referred to as BH curve or hysteresis curve) is illustrated in FIG. 3B. The magnetization curve actually includes two curves 310A and 310B. The nominal slope in the middle of each curve represents the permeability µ (i.e., B/H). The ends of the curves at high and low magnetic flux densities indicate saturation where the slope of the curves approached zero. When unsaturated, as the magnitude of H is increased in the positive or negative direction, B is increased proportionally. However, as H is increased to the saturation point (where the curves flatten), B is no longer increased. Curve 310A represents the relationship between B and H when H is increased from negative saturation to positive saturation, and curve 310B represents the relationship between B and H when H is decreased from positive saturation to negative saturation. The difference in the curves in known as hysteresis

Returning to the chart in FIG. 3A, the Y-axis indicates how much power in milliwatts is measured at load 202. There were 16 measurements of different ferrite materials and the corresponding measurements (numbered 1-16) are listed along the X-axis.

The power leakage to load 202 shown in FIG. 3A may be measured in multiple different ways. In one variation, power leakage is derived from the amount of power transmitted from coil 110 and the amount of power received by coil 108. For example, power inputted to coil 110 and power received on coil 108 are measured in the configuration shown in FIGS. 2A and 2B, without a shield 106 and without a load 102. This measurement may provide a baseline power loss, which is represented as measurement 300A in FIG. 3A. The Y-axis of FIG. 3A is the difference between the input power from coil 110 and the output power received on coil 108, offset to zero at the baseline value 300A. A second measurement is taken without the shield 106, but with load 102 to derive a worst case power leakage, which is represented as measurement 300B. Measurements 302A-D, 304A-C, 306A-C and 308A-D, represent the same measure of power loss with shield 106 made up of the four different families of materials, respectively. In each measurement, transmission power from coil 110 may be changed until the same output power is received by receiving coil 108, which is consistent with how pad 104 operates during nominal use to charge a device 102.

The properties of materials used in measurements of Figure 3 have been summarized in Table 1 below.

**Table 1:**

| Material | Thicknesses | Relative magnetic permeability |
|---|---|---|
| 302 | 70µm, 100µm, 200µm, 300µm | 130 |
| 304 | 100µm, 140µm, 260µm | 500 |
| 306 | 100µm, 200µm, 300µm | 100 |
| 308 | 50µm, 100µm, 200µm, 300µm | 100 |

Measurements 302A-D correspond to material 302 comprising Si, Al, Zn, and Fe, and having a magnetic permeability of u = 130 and various thicknesses. Measurement 302A corresponds to material 302 having a thickness of 70 micrometers (µm), measurement 302B corresponds to material 302 having a thickness of 100 µm, measurement 302C corresponds to material 302 having a thickness of 200 µm, and measurement 302D corresponds to material 302 having a thickness of 300 µm. Material 302 corresponds to materials A and B of Table 2 discussed further below. Some embodiments of material 302 may consist essentially of Si, Al, Zn, and Fe.

Measurements 304A-C correspond to material 304 comprising Si, Al, Zn , Fe and also additional metals Mn, Mo, and Cu having a magnetic permeability of u = 500 and having various thicknesses. Measurement 304A corresponds to material 304 having a thickness of 100 µm, measurement 304B corresponds to material B having a thickness of 140 µm, and measurement 304C corresponds to material 304 having a thickness of 260 µm. Material 304 corresponds to material C of Table 2 further discussed below. Some embodiments of material 304 may consist essentially of Si, Al, Zn, Fe, Mn, Mo, and Cu.

Measurements 306A-C correspond to material 306 comprising Si, Al, Zn, and Fe, having a magnetic permeability of u = 100 and having various thicknesses. Measurement 306A corresponds to material 306 having a thickness of 100 µm, measurement 306B corresponds to material 306 having a thickness of 200 µm, and measurement 306C corresponds to material 306 having a thickness of 300 µm. Some embodiments of material 306 may consist essentially of Si, Al, Zn, and Fe.

Measurements 308A-D correspond to material 308 comprising Si, Al, Zn, Fe and having a magnetic permeability of u = 100 and having various thicknesses. Measurement 308A corresponds to material 308 having a thickness of 50µm, measurement 308B corresponds to material 308 having a thickness of 100 µm, measurement 308C corresponds to material 308 having a thickness of 200 µm, and measurement 308D corresponds to material 308 having a thickness of 300 µm. Some embodiments of material 302 may consist essentially of Si, Al, Zn, and Fe.

The chart in FIG. 3A illustrates that different materials may behave in different ways when exposed to a magnetic field. Measurements 302A-D indicate that there are diminishing declines in power leakage as the thickness of material 302 increases. For instance, as seen in FIG. 3A, measurements 302C and 302D show similar power leakage, even though the ferrite shield used for measurement 302D is 100 micrometers thicker than the shield used for measurement 302C. Measurements 304A-C of material B indicate that power loss is relatively constant regardless of thickness. Measurements 306A-C indicate that power loss linearly decreases with increased thickness of material 306. Measurements 308A-D indicate that power loss decreases faster with increased thickness of material 308.

In view of these differing characteristics, shield 106 may be composed of two or more layers where each layer contains a different material, has a different magnetic permeability, different BH curve, has a different thickness, and/or has a different shape. Shield 106 may be composed of multiple layers where each layer has different properties to decrease the thickness of device 102 and to maintain protection of internal components within device 102.

In an example, shield 106 may be a double-layer ferrite shield having a first layer composed of a higher magnetic permeability material and a second layer composed of a lower magnetic permeability material. The lower magnetic permeability material may have a higher saturation level than the higher magnetic permeability material. In various examples, the first layer may have a magnetic permeability below 200, and the second layer may have a magnetic permeability above 200. Other examples may have other different relative permeabilities.

Embodiments may include as one layer, for example, Vitroperm®, which has a relative permeability of approximately 10,000 at a frequency in the range of 100-200 KHz. Other embodiments may include layers comprising Fe alone or combined with one or more elements selected from a group consisting of Si, Al, Zn, Ni, Co, Cu, Nb, B, Mn, Mo, and Cu.

Various embodiments may include a first layer composed of the higher magnetic permeability material selected based on its shielding properties of the alternating magnetic flux generated by coil 110, and the second layer composed of the lower permeability material selected based on its shielding properties of the non-alternating magnetic flux generated by optional alignment magnetic 112.

For example, the lower permeability layer material may be selected so that it shields the load from, and does not saturate in the presence of, the magnetic field of a permanent magnet, such as magnet 112 included in pad 104. The higher permeability layer may be selected such that it shields the load from, and does not saturate in the presence of, a magnetic field generated by coil 110. A suitable combination of layers composed of high and low magnetic permeability materials may, in various embodiments, provide sufficient protection in both cases (i.e., a pad with and without magnet 112) and result in a thinner shield compared to prior art solutions.

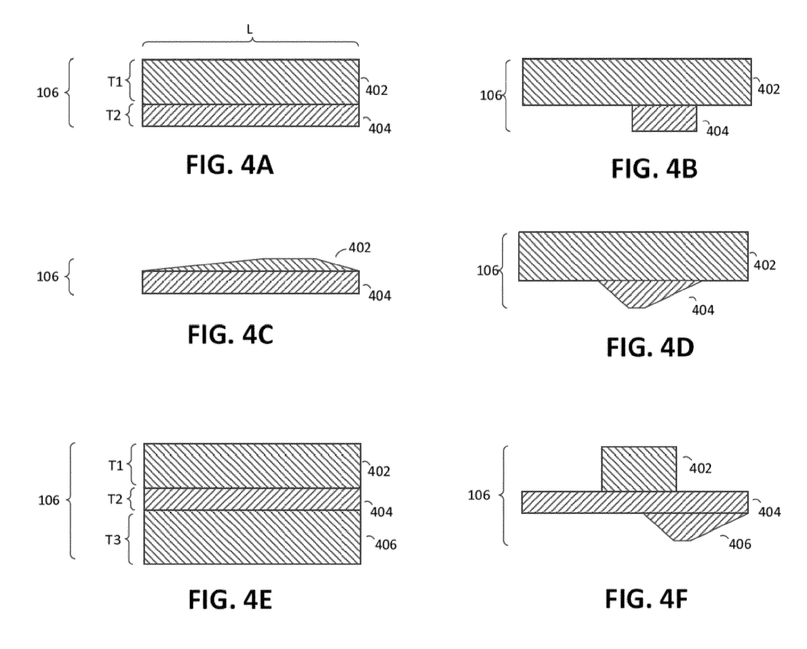

The shape of the layers within shield 106 may be varied to provide differing protections at various locations within device 102. FIGS. 4A-F illustrate cross sectional views of ferrite shields having multiple layers in accordance with example embodiments. The example cross sections are taken along line A-A' of FIG. 1. In an example, ferrite shield 106 may include a first layer 402 and a second layer 404. Each layer may have a predetermined magnetic permeability and thickness. In some examples, first layer 402 may be thicker than second layer 404, as seen in FIG. 4A. As shown, first layer 402 may have thickness T1 and second layer may have thickness T2. Layers 402 and 404 may have a same length L. For example, layer 402 may be material A in table 2 below having a thickness of 200µm and layer 404 may be material E in the table 2 having a thickness of 80µm, giving a total thickness of 280µm (plus adhesives).

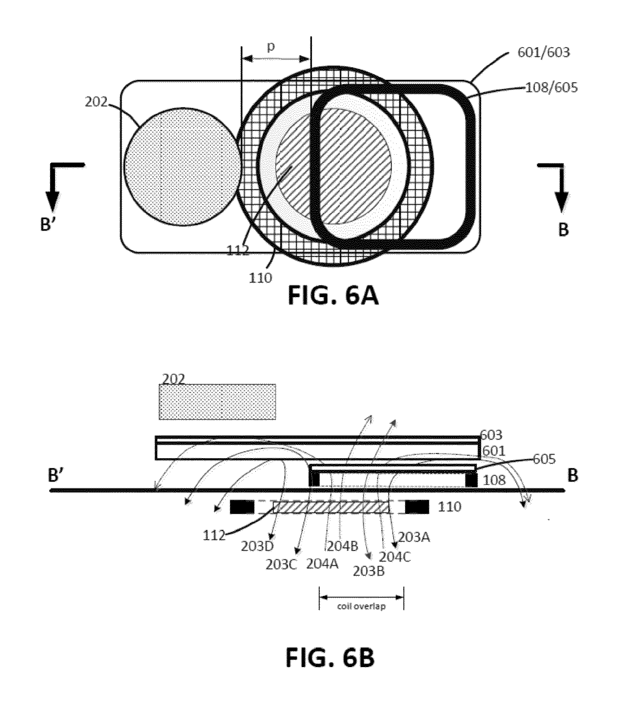

In some examples, the shape of the layers may be varied based on the relationship between a magnetic field and distance. For instance, as shown with respect to FIGS. 6A-6C discussed below, a magnetic field of a permanent magnet may decrease rapidly as a function of distance (e.g., inverse-cube function). In view of this decrease, the thickness and size of shield 106 may be adjusted such that a portion of shield 106 is thicker at a location expected to be closer to magnet 112 when device 102 is placed on pad 104. Portions of shield 106 that are expected to be farther from magnet 112 may be thinner and/or composed of a high magnetic permeability material.

Examples of layers of ferrite shield 106 having differing shapes and sizes are shown in FIGS. 4B-4D and 4F. As shown in FIG. 4B, layers 402 and 404 may have differing lengths and thicknesses. In other examples, one or more layers may have irregular shapes, as shown in FIGS. 4C-4D and 4F. As seen in FIG. 4C, a thickness of layer 402 may increase from each end until leveling off at a maximum thickness, similar to a trapezoid. As seen in FIG. 4D, layer 404 may only cover a certain portion of layer 402 and may be tapered until reaching a maximum thickness. Other configurations of layers 402 and 404 may also be used.

In further examples, shield 106 may include three or more layers. As seen in FIG. 4E, layers 402, 404, and 406 have the same length but different thicknesses T1, T2, and T3. As seen in FIG. 4F, layers 402, 404, and 406 may be a combination of geometric and irregular shapes. Other combinations of layers 402, 404, and 406 having geometric shapes, irregular shapes, or both, may also be used.

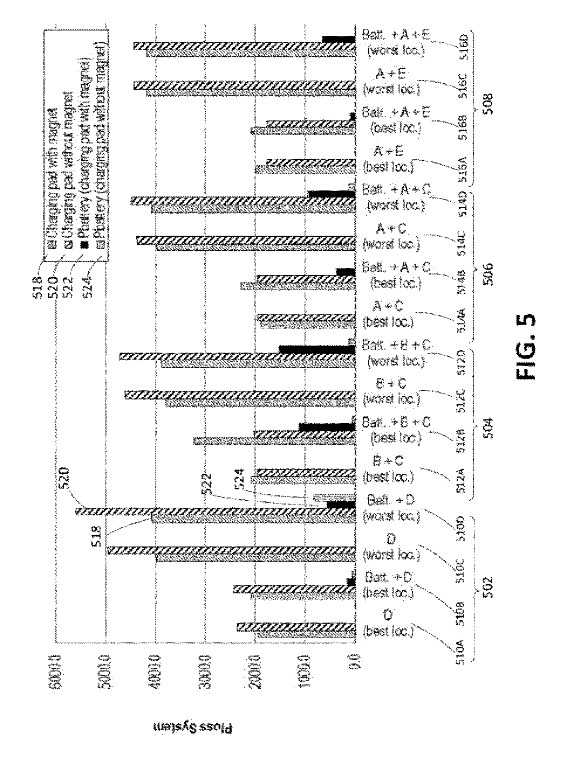

To control saturation of the ferrite shield 106 and to reduce power leakage, layers of shield 106 may be composed of differing materials having different magnetic permeabilities. FIG. 5 illustrates a chart depicting power leakage for various different ferrite shields in accordance with example embodiments. Power leakage measurements may be taken at either a load 202, as shown in FIG. 2, or at battery 120 shown in FIG. 1. The chart in FIG. 5 includes measurements of single layer and dual layer ferrite shields with materials listed in table 2 below. Measurement family 502 corresponds to measurements of a single-layer ferrite shield composed of material D, measurement family 504 corresponds to a two-layer ferrite shield composed of material B in a first layer and material C in a second layer, measurement family 506 corresponds to a two-layer ferrite shield composed of material A in a first layer and material C in a second layer, and measurement family 508 corresponds to a two-layer ferrite shield composed of material A in a first layer and material E in a second layer.

With reference to Table 2 and Figure 5, materials A and B comprise Si, Al, Zn, and Fe with relative permeability of 130 at the operating frequency of the wireless charger (e.g., 100-200 kHz). In the measurements, the thickness of material A was 200 µm and thickness of material B was 70 µm. Material C comprises Si, Al, Zn, and Fe and other metals such as Mn, Mo, and Cu. Relative permeability of material C is 500 at the operating frequency of the wireless charger and thickness in the measurements was 140 µm. Material D comprises Si, Al, Zn, and Fe and its relative permeability at the operating frequency of the wireless charger is 42 and thickness in the measurements was 400 µm. Material E comprises Fe, Cu, Nb, Si, and B. The relative permeability of material E is 10,000 at the operating frequency of the wireless charger and its thickness in the measurements was approximately 80 µm.

**Table 2**

| Material | Thickness | Relative magnetic permeability |
|---|---|---|
| A | 200µm | 130 |
| B | 70µm | 130 |
| C | 140µm | 500 |
| D | 400µm | 42 |
| E | Approx. 80µm | 10,000 |

Measurement families 502, 504, 506, and 508 include measurements having different amounts of overlap between coils 108 and 110, and some measurements where a battery is not included as an additional load behind coil 106 in device 102. Within each measurement family are multiple measurement groups. Measurement family 502 corresponds to measurement groups 510A-D having various different configurations. In some measurement groups, coils 108 and 110 may be concentric (see "best loc." designation of measurement group 510A in FIG. 5) and misaligned (see "worst loc." designation of measurement group 510C in FIG. 5). For instance, measurement group 510A includes power leakage measurements when using a single layer ferrite shield composed of material D, device 102 not having a battery, and coils 108 and 110 being concentrically aligned. Measurement group 510B includes power leakage measurements when using a single layer ferrite shield composed of material D, device 102 having a battery, and coils 108 and 110 being concentrically aligned. Measurement group 510C includes power leakage measurements when using a single layer ferrite shield composed of material D, device 102 not having a battery, and coils 108 and 110 being misaligned. Measurement group 510D includes power leakage measurements when using a single layer ferrite shield composed of material D, device 102 having a battery, and coils 108 and 110 being misaligned. Measurement groups 512A-D, 514A-D, and 516A-D may include data of measurements using different ferrite shields similar to that described for measurement groups 510A-D.

Within each measurement group, the chart shown in FIG. 5 provides four different power leakage measurements. Two of the four power loss measurements are measured at load 202 and the other two are measured at battery 120 as an additional load behind receiving coil 108. In all of the tests reflected in FIG. 5, other phone structure such as a phone cover, internal metal chassis, external camera components, etc., are further included, which increase the measured power leakage during the tests.

Measurement group 510D, for example, includes load power leakage measurement 518 taken when pad 114 includes magnet 112, load power leakage measurement 520 taken when magnet 112 is omitted from pad 104, battery power leakage measurement 522 taken when pad 114 includes magnet 112, and battery power leakage measurement 524 taken when magnet 112 is omitted from pad 104. Because there is no battery included in measurement groups 510A, 510C, 512A, 512C, 514A, 514C, 516A, and 516C, there are no battery power leakage measurements depicted in the chart.

By looking at measurement family 504 for the B+C dual layer ferrite shield combination, power leakage is detected at battery 120 even when coils 108 and 110 are concentrically aligned. Such power leakage may occur because material B is thin (e.g., 70 micrometers) and saturates easily.

In other examples, a two layer shield composed of materials A and C having a total thickness of 340 µm (e.g., 200µm + 140µm = 340µm) or a two layer shield composed of materials A and E having a total thickness of 280µm (200µm + 80µm = 280µm) may be used. These layer combinations have power leakage characteristics that are comparable with a ferrite shield composed of material D (see FIG. 5, compare power leakage measurements for measurement families 506 and 508 with power leakage measurements for measurement family 502), but are thinner (e.g., 280µm and 340µm respectively as compared to 400µm). Thus, a dual layer ferrite shield may perform similarly or better than a single layer shield, but the dual layer ferrite shield may be thinner.

FIGS. 6A and 6B illustrate a test configuration and data results to evaluate tradeoffs between power leakage and different shield sizes (e.g., areas) based on the lateral distance between the load 202 and the transmitting coil 110 in accordance with example embodiments. As in FIGS 2A and 2B, coil 108 is offset from coil 110 to the greatest extent (minimizing coil overlap) at which pad 104 keeps the transmission coil 110 active. In this worst case condition, pad transmission power in coil 110 is at its maximum power in order to maintain the same reception power in coil 108. Because transmission power in coil 110 is at its greatest, but receiving coil 108 has minimal overlap with the field generated by coil 110, magnetic field strength away from receiving coil 108 (e.g., in the opposite direction at which 108 is moved relative to 110) will be at its greatest. In FIGS. 6A and 6B, each layer of the shield is depicted separately as 601 and 603, respectively. The field not passing through the receiving coil is not absorbed by the receiving coil. However, the shields 601 and/or 603 still provide a low reluctance path for the magnetic flux generated by coil 110 and magnet 112, and may reduce the spread of magnetic flux in the left and right directions with respect to FIG. 6B. The test configuration of FIGS. 6A and 6B may also include a ferrite 605 comprising material D with thickness of 400 µm behind the receiver coil 108. Ferrite 605 is however optional and it may not be present in some embodiments of the invention.

Previously, in the configuration shown in FIGS. 2A and 2B, load 202 was placed directly behind shield 106 to evaluate how different thicknesses and layering affected shielding. In FIGS. 6A and 6B, power leakage measurements are made with the load placed away from receiving coil 108 at different distances, p, for various shield materials. In FIGS. 6A and 6B, the shields 601 and 603 are larger than the dimensions of the receiving coil 108 to protect also the load 202.

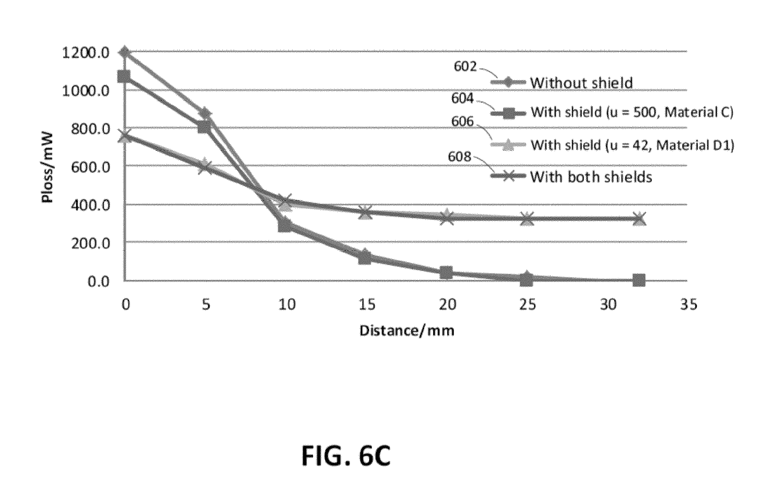

FIG. 6C illustrates the results of the tests performed with the configuration of FIGS. 6A and 6B. In various examples, similar results may be obtained through computer simulation of the structure and magnetic field. In FIG. 6C, line 602 corresponds to power leakage measurements as a function of distance p without a ferrite shield, line 604 corresponds to power leakage measurements as a function of distance with a ferrite shield composed of material C from table 2 above, line 606 corresponds to power leakage measurements as a function of distance with a ferrite shield D1 composed of the same material D from table 2 above, but at a thickness of 600 µm, and line 608 corresponds to power leakage measurements as a function of distance with a two-layered ferrite shield with a cross-section as shown in FIG. 4A, with a first layer 601 composed of material D1 and a second layer 603 composed of material C.

With respect to line 602 (e.g., without a ferrite shield) the magnetic field from coil 110 and from magnet 112 decrease rapidly as a function of distance (e.g., inverse-cube function). Line 604 (e.g., material C) only slightly reduces power leakage below that of 602 for shorter distances (e.g., 0 to 10mm), and has no appreciable difference at further distances (e.g., > 10 mm). The performance of material C at the shorter distances in indicative of material C being saturated. Thus, increasing distance p is nearly as effective in reducing power leakage as using a shield composed of material C directly over receiving coil 106.

By adding a layer 601 composed of material D1 to the shield, power leakage is attenuated as a function of distance from 0 to approximately 8 mm as seen by comparing lines 602 and 608. After approximately 8 mm, line 608 crosses line 602, indicating that there is minimal further reduction in power leakage as compared to no shield at all. Further, adding a layer of material D1 to a ferrite shield increased power leakage between 10 mm and 32 mm, as can be seen when comparing line 608 to line 604. The increase in power leakage can result from non-ideal behavior of material D1 (e.g., lower resistivity), that causes power consumption in material D1 due to induced eddy currents and/or magnetic losses. Thus, there are tradeoffs when adding additional layers to a ferrite shield.

In various embodiments, for example, the size of the shielding layer and material can be selected and optimized, based on various factors. As a first factor, the shield layer perimeter may be determined based on the distance from the magnetizing field source at which the shielding provided by the material is less effective than the distance itself in reducing the magnetic field (e.g., as shown in FIG. 6C).

As a second factor, the perimeter, thickness, and material of each layer may be selected to shield magnetic energy from different sources. For example, size, shape, and material of a first layer may be selected to shield a non-alternating field from a magnetic 112 in a first position, while size, shape and material of a second layer may be selected to shield an alternating field from a transmitting coil 110 in a second position.

As another factor, the perimeter, thickness, and material for each shield layer may be selected based on minimizing the amount of magnetic field energy absorbed by the material making up the layer. For example, shielding layers at distances from the magnetic source beyond what is effective to provide effective shielding, may still absorb energy from the magnetic field (e.g., due to non-ideal behavior), thus causing the transmitting coil 110 to increase overall transmit power to transfer the same amount of energy to receiving coil 108. By removing layer material that absorbs energy, but that is not providing effective shielding (e.g., due to distance laterally or in thickness) the overall transmit power (and therefore leakage) may be reduced.

In various examples, each layer of a multiple layer shield may be tailored (e.g., in size, shape and material) individually according to the above factors. For example, the size of layers 402 and 404 in FIG. 4B may be selected to be different based on the above factors applied to each layer separately.

The setup shown in FIGS. 6A-6C is just one example method on how to observe the effects of an alignment aid magnet and various shield sheets. Similar methods may be used for the charging pads without the alignment magnet, for charging systems with different size transmit and/or receive coils, and for shields sheets of different materials, permeabilities, thicknesses, and dimensions.

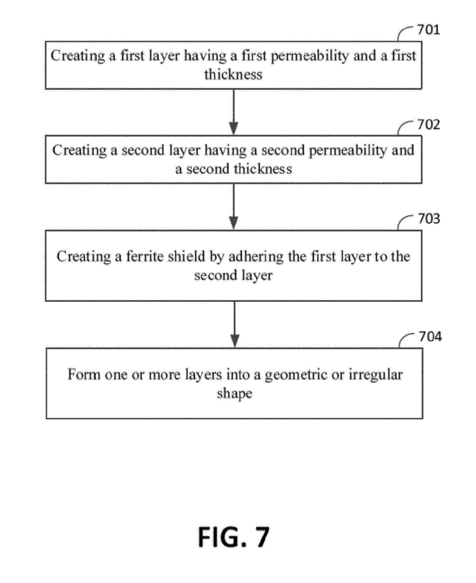

FIG. 7 is a diagram of a method for manufacturing a multi-layered ferrite shield in accordance with example embodiments. In other embodiments, one or more steps indicated in FIG. 7 may be omitted, rearranged or replaced with different steps. Other steps might also or alternatively be added. The steps indicated in FIG. 7 may be performed manually or by manufacturing equipment under control of a processor or other computing device. For convenience, performance of operations by such hardware will be generically described as performance of operations by manufacturing equipment. Such operations may be performed as the result of executing machine-executable instructions stored within one or more memories of manufacturing equipment and/or executing instructions that are stored as hard-coded dedicated logic.

In step 701, manufacturing equipment may create a first layer having first magnetic properties (e.g., permeability, saturation magnetic flux density, Curie point, resistivity, etc.) and a first thickness. In some examples, the first thickness may not be uniform over a length and width of the first layer. In step 702, manufacturing equipment may create a second layer having second magnetic properties and a second thickness. In some examples, the second thickness may not be uniform over a length and width of the second layer.

In step 703, manufacturing equipment may create a ferrite shield by adhering/affixing the first layer to the second layer. Additional layers may also be added to create a ferrite shield of three or more layers. In various embodiments, the multiple layers are adhered together with an adhesive layer between each shield layer. In other embodiments, the multiple layers are integrated into the structure of device 102. For example, multiple layers of shield 106 may be mechanically attached (e.g., soldered, screwed, bonded with epoxy, etc.) to a circuit board over the electronic components of the circuit board. In other variations, the one or more layers may be encapsulated in the body of device 102 (e.g., molded in a thermoplastic casing). In further variations, one or more of the layers of shield 106 may be integrated into a sub-component (e.g., battery) of device 102. Various embodiments may use a combination of such attachment techniques for the different layers (e.g., a first layer encapsulated and a second layer mechanically attached to the circuit board, battery, etc.). The space between each layer may be different (e.g., distance between layer 1 and layer 2 may be different than distance between layer 2 and layer 3. The thickness of the space between layers may be constant or may vary over the length and width of the layers. In some variations, the layers may be tightly bonded with no space other than what is required for adhering/attaching. The above embodiments are just examples and other attachment techniques may be used as well.

In step 704, manufacturing equipment may form one or more layers of shield into a geometric or irregular shape. For example, manufacturing equipment may form one or more layers into a geometric or irregular shape similar to that shown in FIGS. 4A-F. Step 704 may be performed on the already composite of layers created in step 703, or may be performed on each layer individually before being adhered in step 703 (e.g., when created in steps 701 and 702). The method may end, may return to any of the preceding steps, or may repeat one or more times.

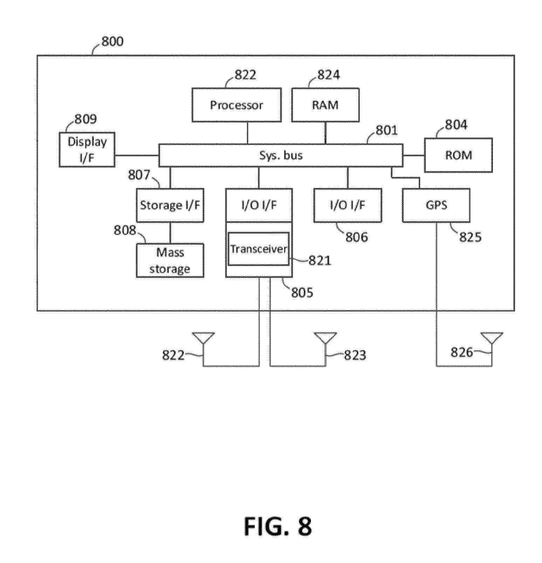

Various types of computers can be used to implement a device such as device 102 according to various embodiments. FIG. 8 shows an exemplary device 800 in accordance with example embodiments. Device 800 includes a system bus 801 which operatively connects one or more processors 822, one or more memories (e.g., random access memory) 824, read-only memory 804, input output (I/O) interfaces 805 and 806, storage interface 807, display interface 809 and global positioning system (GPS) chip 825. Storage interface 807 in turn connects to a mass storage 808. Interface 805 may include a transceiver 821, antennas 822 and 823, and other components for communication in the radio spectrum. Interface 906 and/or other interfaces (not shown) may similarly include a transceiver, one or more antennas, and other components for communication in the radio spectrum, and/or hardware and other components for communication over wired or other types of communication media. GPS chip 825 includes a receiver, an antenna 826 and hardware and/or software configured to calculate a position based on GPS satellite signals.

Mass storage 808 may be a hard drive, flash memory or other type of non-volatile storage device. Processor(s) 822 may be, e.g., an ARM-based processor such as a Qualcomm Snapdragon or an x86-based processor such as an Intel Atom or Intel Core. Device 800 may also include a touch screen (not shown) and physical keyboard (also not shown). A mouse or keypad may alternately or additionally be employed. A physical keyboard might optionally be eliminated.

The foregoing description of embodiments has been presented for purposes of illustration and description. The foregoing description is not intended to be exhaustive or to limit embodiments to the precise form explicitly described or mentioned herein. Modifications and variations are possible in light of the above teachings or may be acquired from practice of various embodiments.

## Claims

1. An apparatus comprising:
a magnetic shield comprising a first layer and a second layer, wherein the first layer comprises a material having a first magnetic permeability and the second layer comprising a material having a second magnetic permeability, wherein the first magnetic permeability is different from the second magnetic permeability and the magnetic shield is configured to reduce exposure of at least one internal component of an electronic device to a magnetic field.

2. The apparatus of claim 1, wherein a thickness of at least one of the first and second layers is non-uniform over a length of the magnetic shield.

3. The apparatus of claim 1 or 2, wherein the first magnetic permeability is below 200 and the second magnetic permeability is above 200.

4. The apparatus of any of claims 1 to 3, wherein the first magnetic permeability is approximately 130 and the second magnetic permeability is approximately 10,000.

5. The apparatus of any of claims 1 to 3, wherein the first magnetic permeability is approximately 130 and the second magnetic permeability is approximately 500.

6. The apparatus of claim 1 or 2, wherein the first magnetic permeability is higher than the second magnetic permeability.

7. The apparatus of any of claims 1 to 6, wherein a thickness of the first layer is approximately 200 micrometers or approximately 70 micrometers.

8. The apparatus of any of claims 1 to 7, wherein a thickness of the second layer is approximately 80 micrometers.

9. The apparatus of any of claims 1 to 8, wherein the first layer is composed of a ferrite material.

10. A method comprising:
creating a first layer having a first magnetic permeability and a first thickness;
creating a second layer having a second magnetic permeability and a second thickness; and
creating a magnetic shield by adhering the first layer to the second layer.

11. The method of claim 10, further comprising varying the first thickness over a length of the magnetic shield.

12. The method of claim 10 or 11, further comprising varying the second thickness over a length of the magnetic shield.

13. The method of any of claims 10 to 12, wherein the first magnetic permeability differs from the second magnetic permeability.

14. The method of any of claims 10 or 13, wherein the first magnetic permeability is higher than the second magnetic permeability.

15. The method of any of claims 10 to 14, wherein the first magnetic permeability is below 200 and the second magnetic permeability is above 200.
